# FASCICULE DE BREVET EUROPEEN

(11) **EP 2 731 908 B1**
(45) Date de publication et mention de la délivrance du brevet: **09.09.2015**
(21) Numéro de dépôt: 12758611.3
(22) Date de dépôt: 12.07.2012
(51) Int. Cl.: B81B 3/00, G01F 1/684, G01F 1/688, G01L 21/12, H01L 41/316, H01L 41/332

(54) **CAPTEUR MINIATURISE A ELEMENT CHAUFFANT ET PROCEDE DE FABRICATION ASSOCIE.**
MINIATURISIERTER SENSOR MIT EINEM HEIZELEMENT UND ZUGEHÖRIGES HERSTELLUNGSVERFAHREN
MINIATURISED SENSOR COMPRISING A HEATING ELEMENT, AND ASSOCIATED PRODUCTION METHOD

(30) Priorité: 13.07.2011 FR 1156409
(43) Date de publication de la demande: 21.05.2014
(73) Titulaire: Centre National de la Recherche Scientifique, 75016 Paris (FR); Ecole Centrale De Lille, 59651 Villeneuve d'Ascq (FR)
(72) Inventeur: VIARD, Romain, 68400 Riedisheim (FR); TALBI, Abdelkrim, F-59110 La Madeleine (FR); PERNOD, Philippe, Jacques, F-59800 Lille (FR); MERLEN, Alain, F-59000 Lille (FR); PREOBRAZHENSKY, Vladimir, F-59650 Villeneuve d'Ascq (FR)
(74) Mandataire: Reboussin, Yohann Mickaël Noël
(86) Numéro de dépôt international: PCT/IB2012/053578
(87) Numéro de publication internationale: WO 2013/008203

(56) Documents cités:
- CHANG LIU ET AL: "A Micromachined Flow Shear-Stress Sensor Based on Thermal Transfer Principles", JOURNAL OF MICROELECTROMECHANICAL SYSTEMS, IEEE SERVICE CENTER, US, vol. 8, no. 1, 1 mars 1999 (1999-03-01), XP011034835, ISSN: 1057-7157 cité dans la demande
- MEUNIER D ET AL: "Realization and simulation of wall shear stress integrated sensors", MICROELECTRONICS JOURNAL, MACKINTOSH PUBLICATIONS LTD. LUTON, GB, vol. 34, no. 12, 1 décembre 2003 (2003-12-01), pages 1129-1136, XP004472673, ISSN: 0026-2692, DOI: 10.1016/S0026-2692(03)00203-9 cité dans la demande
- WANG S N ET AL: "Thermal micropressure sensor for pressure monitoring in a minute package", JOURNAL OF VACUUM SCIENCE AND TECHNOLOGY: PART A, AVS /AIP, MELVILLE, NY., US, vol. 19, no. 1, 1 janvier 2001 (2001-01-01), pages 353-357, XP012005456, ISSN: 0734-2101, DOI: 10.1116/1.1333085

## Description

La présente invention se rapporte au domaine des capteurs à élément chauffant miniaturisés.

Par capteurs miniaturisés, il convient de comprendre qu'il s'agit de capteurs qui présentent au moins une dimension comprise entre quelques microns et quelques centaines de microns.

De tels capteurs peuvent être utilisés pour mesurer une vitesse d'écoulement d'un fluide, un frottement pariétal ou encore une pression.

Un capteur miniaturisé à élément chauffant est par exemple proposé dans l'article de Meunier & al., « Realizafion and simulation of wall shear stress integrafed sensors », Microelectronics Journal 34(2003), pp. 1129-1136 pour mesurer la contrainte pariétale liée à un écoulement de fluide. Un autre exemple de capteur miniaturisé à élément chauffant suspendu au-dessus d'une cavité est présenté dans l'article de Liu & al., "A Micromachined Flow Shear-Stress Sensor Based on Thermal Transfer Principles", JOURNAL OF MICROELECTROMECHANICAL SYSTEMS, IEEE SERVICE CENTER, US, vol. 8, no. 1, 1 mars 1999.

Ce capteur comporte un substrat, une structure d'isolation thermique, un élément chauffant (fil chaud) et des contacts électriques. La structure d'isolation thermique permet de définir une cavité au-dessus de laquelle le fil chaud s'étend, ce fil chaud étant maintenu sur la structure d'isolation thermique par ses extrémités. Les contacts électriques sont disposés sur la structure d'isolation thermique et connectés avec les extrémités du fil chaud, si bien que ce dernier peut être alimenté en électricité pour effectuer un chauffage par effet Joule.

Plusieurs paramètres interviennent dans la qualité de la mesure effectuée avec ce type de capteur.

Tout d'abord, il faut considérer la géométrie du fil chaud.

En effet, il faut de préférence un fil présentant la plus grande longueur L_{fil} possible avec un diamètre hydraulique dₕ le plus faible possible. Le diamètre hydraulique dₕ est défini par la relation :*dₕ =* 4*S*/*P* où S est la section du fil chaud et P son périmètre mouillé.

Un faible diamètre hydraulique du fil chaud limite l'inertie thermique de ce fil et améliore donc la bande passante du capteur.

De plus, en pratique, l'homme du métier considère qu'il est préférable de dimensionner le fil de sorte que L_{fil}/dₕ > 30, pour obtenir un capteur suffisamment sensible. Cette relation est vérifiée pour le capteur proposé par Meunier & al.

La géométrie du fil chaud a donc une influence sur la sensibilité du capteur et sur sa bande passante.

Ensuite, il faut également considérer la nature des matériaux utilisés pour former le fil.

En effet, la nature des matériaux choisis intervient sur la valeur du coefficient de température (TCR pour « *Temperature Coefficient* Résistance » selon la terminologie anglo-saxonne) du fil et par suite, sur la sensibilité du capteur.

De plus, la nature des matériaux choisis pour le fil défini la conductivité thermique de ce fil, laquelle doit être la plus élevée possible pour améliorer la bande passante du capteur.

Dans l'article de Meunier & al., un fil chaud en polysilicium dopé au bore a été choisi à cet effet.

Enfin, pour éviter les pertes de chaleur parasites, lesquelles influent également sur la bande passante du capteur, il convient d'isoler thermiquement le fil chaud du substrat autant que possible.

A cet effet, le fil chaud du capteur proposé par Meunier & al.s'étend au-dessus d'une cavité d'air, par nature faiblement conducteur thermique.

A cet effet également, une structure d'isolation thermique est utilisée entre les extrémités du fil chaud et le substrat. Cette structure d'isolation thermique est en l'occurrence réalisée en nitrure de silicium car ce matériau présente, comme l'air, une faible conductivité thermique.

Le capteur proposé par Meunier & al., de conception relativement simple, présente une sensibilité adéquate pour les mesures de frottement pariétales.

Toutefois, ce type de capteur peut difficilement être employé pour d'autres mesures que celles concernant des mesures de frottement pariétales ou des mesures de vitesses d'écoulements faibles.

En effet, le fil chaud est fragile et peut difficilement être employé pour des mesures de vitesse dépassant typiquement 20m/s, au risque de casser. Cette fragilité est liée au fait que le diamètre hydraulique dₕ de ce fil est faible, que son rapport L_{fil}/dₕ est élevé et qu'il est suspendu au-dessus de la cavité.

De nombreux capteurs à éléments chauffants de conceptions différentes ont été proposés.

Le capteur proposé par Chiang Lu & al., "A micromachined flow shear-stress sensor based on thermal fransfer principles" Journal of Microelectromechanical Systems, vol. 8 (1), pp. 90 à 99 est particulièrement intéressant.

Ce capteur comporte un substrat muni d'une cavité, une structure d'isolation thermique suspendue au-dessus de la cavité par l'intermédiaire de zones de liaison avec le substrat et, un élément chauffant (fil chaud) disposé sur la structure d'isolation thermique.

Dans cette conception, la structure d'isolation thermique se présente sous la forme d'une membrane suspendue au-dessus d'une cavité réalisée dans le substrat.

Le fil chaud vérifie la relation L_{fil}/ldₕ > 30 et est réalisé en polysilicium dopé au phosphore. Les caractéristiques de ce fil (géométrie, TCR, conductivité thermique,...) sont donc voisines des caractéristiques du fil chaud mis en oeuvre dans le capteur proposé par Meunier & al.

Par ailleurs, la structure d'isolation thermique mise en oeuvre par Chiang & Lu. présente une conductivité thermique identique à la structure d'isolation thermique du capteur de Meunier & al., dans la mesure où elle est également réalisée en nitrure de silicium.

La sensibilité de ce capteur devrait être comparable à celle du capteur proposé par Meunier & al.

Cependant, ce capteur se distingue principalement du capteur proposé par Meunier & al. par la géométrie de la structure d'isolation thermique (membrane), laquelle permet de recouvrir la cavité réalisée dans le substrat pour y faire régner un vide poussé.

Dans la mesure où le fil chaud est supporté par la membrane, on comprend que ce capteur est plus robuste que le capteur proposé par Meunier & al. La robustesse de ce capteur est également améliorée par une épaisseur plus importante du fil chaud (0,45µm pour Chiang Lu & al. Contre 0,3µm pour Meunier & al.)

Il est donc envisageable d'utiliser la structure du capteur proposé par Chiang Lu & al. pour effectuer des mesures de vitesse d'écoulements plus élevées qu'avec le capteur proposé par Meunier & al. L'article de Chiang Lu & al. précise d'ailleurs que leur capteur a été testé à des vitesses de 25m/s.

En revanche, ce capteur confère une bande passante comparable à la bande passante du capteur proposé par Meunier & al., malgré la mise en oeuvre d'une cavité sous vide poussé sous la membrane isolante thermiquement, la cavité limitant les échanges thermiques entre la membrane et la cavité.

En effet, les auteurs précisent que la fréquence de coupure de leur capteur est de 1,9kHz (courant constant) alors que la fréquence de coupure du capteur proposé par Meunier & al. est d'environ 2kHz (courant constant).

Ceci s'explique probablement par les pertes thermiques liées à la conduction dans la membrane et par l'épaisseur plus importante du fil chaud. La mise en oeuvre d'un vide poussé sous la membrane ne permet donc, apparemment, que de compenser les inconvénients, sur la bande passante, liés à la mise en oeuvre d'une membrane isolante thermiquement et d'une épaisseur plus importante pour le fil chaud.

Un objectif de l'invention est de proposer un capteur miniaturisé, à la fois sensible, robuste et dont la bande passante est accrue par rapport aux capteurs connus.

Pour atteindre cet objectif, l'invention propose un capteur miniaturisé à élément chauffant comportant un substrat, une cavité et une structure d'isolation thermique suspendue au-dessus de la cavité par l'intermédiaire de zones de liaison avec le substrat, caractérisé en ce que la structure d'isolation thermique comprend au moins deux ponts s'étendant au-dessus de la cavité entre ses deux zones de liaison avec le substrat, l'élément chauffant étant supporté par les ponts en s'étendant transversalement par rapport aux ponts.

Le dispositif pourra prévoir d'autres caractéristiques techniques, prises seules ou en combinaison :
- la longueur L d'un pont est comprise entre 10µm et 80µm ;
- la largeur l d'un pont est comprise entre 5µm et 10µm ;
- la distance D entre les deux ponts est comprise entre 20µm et 40µm ;
- l'épaisseur e de la structure d'isolation thermique, en particulier des ponts, est comprise entre 100nm et 500nm ;
- la hauteur h de la cavité est comprise entre 50nm et 500µm ;
- la largeur a de l'élément chauffant est comprise entre 1µm et 5µm ;
- l'épaisseur b de l'élément chauffant est comprise entre 50nm et 500nm ;
- l'élément chauffant comporte plusieurs couches de matériau conducteurs de l'électricité, une couche étant réalisée en un matériau présentant une contrainte résiduelle en tension et la couche attenante étant réalisée en un matériau présentant une contrainte résiduelle en compression, les épaisseurs de ces couches étant adaptées pour compenser les contraintes résiduelles entre les différentes couches afin d'obtenir une contrainte résiduelle totale de l'élément chauffant inférieure à une première valeur limite, par exemple de 250MPa ;
- l'élément chauffant comporte :
   - une première couche de platine ;
   - au moins une bicouche formée par une couche de Nickel revêtue d'une couche de Tungstène ;
   - une deuxième couche de platine.
- la structure d'isolation thermique comporte plusieurs couches de matériau isolant thermiquement, une couche étant réalisée en un matériau isolant thermiquement et présentant une contrainte résiduelle en tension et la couche attenante étant réalisée en un matériau isolant thermiquement et présentant une contrainte résiduelle en compression, les épaisseurs de ces couches de matériau isolant thermiquement étant adaptées pour compenser les contraintes résiduelles entre les différentes couches afin d'obtenir une contrainte résiduelle totale de la structure inférieure à une deuxième valeur limite, par exemple de 250MPa ;
- la structure d'isolation thermique comprend au moins une bicouche formée d'une couche de dioxyde de silicium et d'une couche de nitrure de silicium ;
- la structure d'isolation thermique comprend une lame s'étendant sous l'élément chauffant entre les deux ponts, ladite lame d'isolation thermique intégrant un ruban réalisé en un matériau conducteur électrique, le ruban étant isolé électriquement de l'élément chauffant par ladite lame ;
- la structure d'isolation thermique comprend deux lames s'étendant sous l'élément chauffant entre les deux ponts, deux rubans réalisés en un matériau conducteur de l'électricité et séparés par une lame d'air étant disposés entre les deux lames de la structure d'isolation thermique, de sorte que ces rubans sont isolés électriquement de l'élément chauffant ;
- la structure d'isolation thermique comprend au moins deux autres lames d'isolation thermique s'étendant entre les deux ponts, de part et d'autre de l'élément chauffant, ces deux autres lames supportant chacun un ruban réalisé en un matériau conducteur électrique ;
- la structure d'isolation thermique est réalisée en un matériau piézoélectrique déposé sur un isolant thermique et comporte des transducteurs pour ondes acoustiques de surface ;
- le substrat étant réalisé en un matériau piézoélectrique, un résonateur à ondes acoustiques de surface est disposé sur le substrat, au fond de la cavité ;
- le capteur comprend une plaque en matériau piézoélectrique sur le fond de la cavité, ladite plaque étant munie en surface d'un résonateur à ondes acoustiques de surface ;
- la structure d'isolation thermique comprend un nombre N de ponts supérieur ou égal à trois sur lesquels l'élément chauffant est disposé.

Pour atteindre cet objectif, l'invention propose également un procédé de fabrication d'un capteur selon l'une des revendications précédentes, caractérisé en ce qu'il comprend les étapes suivantes :
(a) déposer au moins une couche de matériau isolant thermique sur un substrat ;
(b) déposer au moins un élément réalisé en un matériau conducteur de l'électricité sur ladite au moins une couche de matériau isolant thermique ;
(c) réaliser une gravure sous plasma de la structure obtenue à l'étape (b) pour définir la forme de la structure d'isolation thermique avec au moins deux ponts s'étendant entre deux zones de liaison de ladite structure d'isolation thermique avec le substrat ;
(d) réaliser une gravure par voie chimique gazeuse pour définir la cavité du substrat au-dessus de laquelle la structure d'isolation thermique s'étend.

Le procédé pourra comprendre l'une au moins des caractéristiques suivantes, prises seules ou en combinaison :
- préalablement à l'étape (a), il est prévu une étape de dépôt localisé d'une couche d'arrêt sur le substrat suivie d'une étape de dépôt, sur la couche d'arrêt, d'une couche sacrificielle d'épaisseur prédéterminée ;
- l'étape (b) consiste à déposer plusieurs couches de matériaux conducteurs de l'électricité successivement, une couche étant réalisée en un matériau présentant une contrainte résiduelle en tension et la couche attenante étant réalisée en un matériau présentant une contrainte résiduelle en compression, les épaisseurs de ces couches de matériau isolant étant adaptées pour compenser les contraintes résiduelles entre les différentes couches afin d'obtenir une contrainte résiduelle totale de l'élément inférieure à une première valeur limite, par exemple de 250MPa ;
- l'étape (a) consiste à déposer plusieurs couches de matériaux isolants thermiquement successivement, une couche étant réalisée en un matériau présentant une contrainte résiduelle en tension et la couche attenante étant réalisée en un matériau présentant une contrainte résiduelle en compression, les épaisseurs de ces couches de matériau isolant étant adaptées pour compenser les contraintes résiduelles entre les différentes couches afin d'obtenir une contrainte résiduelle totale de la structure d'isolation thermique inférieure à une deuxième valeur limite, par exemple de 250Mpa.

D'autres caractéristiques, buts et avantages de l'invention seront énoncés dans la description détaillée ci-après faite en référence aux figures suivantes :
- la figure 1 représente un capteur conforme à l'invention, selon une vue en perspective ;
- la figure 2 représente le capteur de la figure 1, selon une vue de dessus ;
- la figure 3 représente le capteur de la figure 1, selon une vue de côté ;
- les figures 4(a) à 4(d) représentent les différentes structures intermédiaires obtenues lors de la fabrication du capteur représenté sur les figures 1 à 3 ;
- la figure 5 fournit l'évolution de la tension normalisée aux bornes d'un pont de Wheatstone relié à l'élément chauffant du capteur représenté sur les figures 1 à 3, en fonction du débit de fluide s'écoulant dans la cavité de ce capteur ;
- la figure 6 représente, selon une vue en perspective, une variante de réalisation d'un capteur conforme à l'invention, permettant de mesurer une pression par effet Pirani ;
- la figure 7 fournit l'évolution de la tension normalisée aux bornes d'un pont de Wheatstone relié à l'élément chauffant du capteur représenté sur la figure 6, en fonction de la pression régnant dans la cavité de ce capteur ;
- la figure 8 représente, selon une vue en perspective, une variante de réalisation du capteur représenté sur les figures 1 à 3 ;
- la figure 9 représente, selon une vue en perspective, une variante de réalisation du capteur représenté sur la figure 8;
- la figure 10 représente, selon une vue en perspective, une autre variante de réalisation du capteur représenté sur les figures 1 à 3;
- la figure 11 représente, selon une vue en perspective, une variante de réalisation reprenant des éléments de conception spécifiques aux variantes des figures 9 et 10 ;
- les figures 12(a) et 12(b) représentent, selon des vues en perspective, d'autres variantes du capteur représenté sur les figures 1 à 3 ;
- les figures 13(a) et 13(b) représentent également, selon des vues en perspective, d'autres variantes du capteur représenté sur les figures 1 à3;
- les figures 14(a) et 14(b) représentent, toujours selon des vues en perspective, des variantes du capteur représenté sur la figure 6 ;
- la figure 15 représente, selon une vue en perspective prise au microscope à balayage électronique, un capteur conforme à l'invention comportant N mailles élémentaires en série, chaque maille étant représentative du capteur représenté sur les figures 1 à 3 ;
- les figures 16(a) à 16(e) représentent les différentes structures intermédiaires obtenues lors de la fabrication d'un double capteur conforme à l'invention.

Le capteur 1 à élément chauffant selon l'invention comprend un substrat 2, une cavité 20 en l'occurrence formée dans le substrat 2 et une structure d'isolation thermique 3 suspendue au-dessus de la cavité 20 par l'intermédiaire de zones de liaison 31, 32 avec le substrat 2.

La structure d'isolation thermique 3 comprend au moins deux ponts 33, 34 s'étendant au-dessus de la cavité 20, transversalement par rapport aux zones de liaison 31, 32 de la structure d'isolation thermique 3 avec le substrat 2. L'élément chauffant 4 est par ailleurs supporté par les ponts 33, 34 en s'étendant transversalement par rapport à ceux-ci.

Par ailleurs, les extrémités de l'élément chauffant sont connectées à des contacts électriques (non représentés). Un courant électrique peut ainsi traverser l'élément chauffant 4 afin que celui-ci effectue un chauffage par effet Joule.

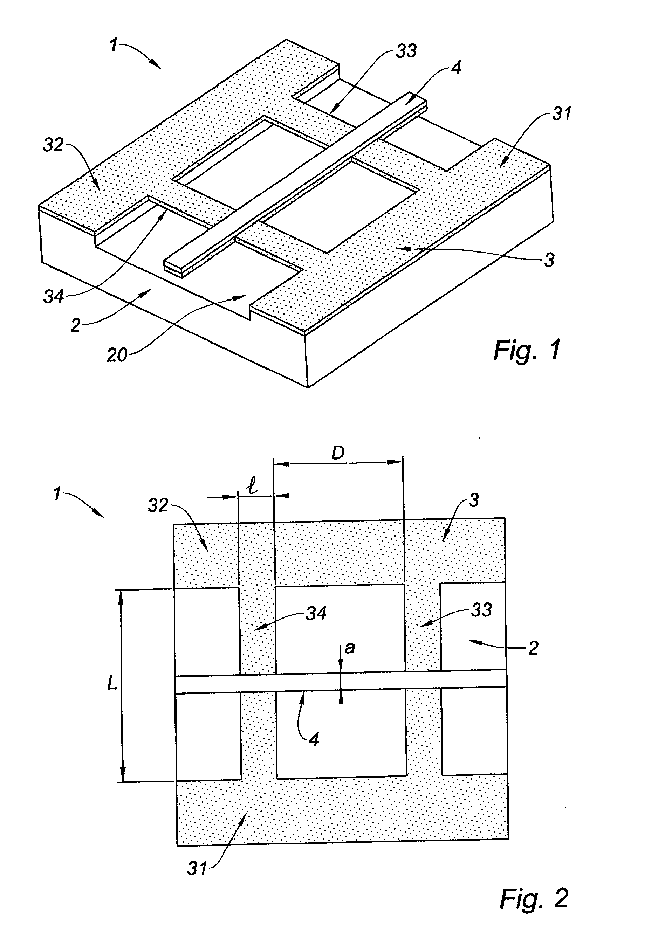

La largeur a de l'élément chauffant 4 est comprise entre 1µm et 5µm. L'épaisseur b de l'élément chauffant 4 est comprise entre 50nm et 500nm. La longueur L_{fil} de l'élément chauffant 4 vaut 2(D+I) compte tenu de la représentation de la figure 1 : elle est comprise entre 50µm et 100µm.

Les dimensions de l'élément chauffant 4 vérifient donc largement la relation L_{fil}/dₕ > 30, ce facteur étant même supérieur à 50.

Le capteur 1 présentera donc une grande sensibilité.

Par ailleurs, les ponts 33, 34 de la structure d'isolation thermique 3 confèrent au capteur une grande robustesse, en servant de support à l'élément chauffant 4.

La robustesse du capteur pourra être ajustée en fonction de l'application envisagée, en choisissant les paramètres géométriques caractéristiques de chacun de ces ponts, à savoir la longueur L, la largeur l, l'épaisseur e et la distance D séparant les deux ponts 33, 34.

Ainsi, la longueur L d'un pont 33, 34 pourra être comprise entre 10µm et 80µm. La largeur l d'un pont 33, 34 pourra être comprise entre 5µm et 10µm. L'épaisseur e d'un pont 33, 34 pourra être comprise entre 100nm et 500nm. La distance D entre les deux ponts 33, 34 pourra être comprise entre 20µm et 40µm.

Il convient de noter que l'épaisseur e des ponts 33, 34 correspond plus généralement à l'épaisseur de la structure d'isolation thermique 3.

De plus, la géométrie de la structure d'isolation thermique 4 confère une grande liberté de choix dans son dimensionnement pour gérer les contraintes contradictoires liées à l'obtention d'un capteur à la fois robuste, sensible et offrant une large bande passante (faibles pertes thermiques, temps de réponse court).

En effet, le choix des rapports L/l, D/l et D/a résulte d'un compromis entre l'efficacité de l'isolation thermique de l'élément chauffant 4 et la robustesse du capteur 1. Plus ces rapports sont élevés, plus l'isolation thermique de l'élément chauffant 4 est efficace, mais plus le capteur 1 est fragile.

Par ailleurs, le choix des paramètres a, b et e résulte quant à lui d'un compromis entre la robustesse du capteur 1 et son inertie thermique, cette dernière influant sur la bande passante du capteur 1. Plus les valeurs de ces paramètres sont faibles, plus le temps de réponse du capteur 1 est court (élargissement de la bande passante), mais plus le capteur 1 est fragile.

Les conceptions proposées dans l'état de la technique n'offrent pas cette liberté de choix, laquelle permet de répondre au problème technique posé par l'invention.

L'élément chauffant 4 peut être réalisé en un matériau métallique ou avec un matériau semiconducteur dopé tel que le polysilicium, le diamant ou le carbure de silicium (SiC).

Lorsqu'un matériau métallique est utilisé, l'élément chauffant 4 peut comprendre au moins l'un des matériaux métalliques suivants : Ag, Ti, Cr, Al, Cu, Au, Ni, W ou Pt.

Avantageusement, l'élément chauffant 4 comporte plusieurs couches de matériau conducteurs de l'électricité, une couche étant réalisée en un matériau présentant une contrainte résiduelle en tension et la couche attenante étant réalisée en un matériau présentant une contrainte résiduelle en compression, les épaisseurs de ces couches étant adaptées pour compenser les contraintes résiduelles entre les différentes couches afin d'obtenir une contrainte résiduelle totale de l'élément chauffant 4 inférieure à une valeur limite.

Ces couches sont avantageusement réalisées par évaporations successives des couches des différents matériaux au travers d'un masque de résine présentant un profil « casquette », ce masque permettant d'obtenir un dépôt localisé.

Il est néanmoins également possible de réaliser le dépôt par pulvérisation.

Cela permet d'obtenir un élément chauffant 4 suffisamment épais pour assurer sa robustesse, tout en évitant un fléchissement qui serait néfaste à la qualité de la mesure effectuée par le capteur 1.

La valeur limite est une valeur au-delà de laquelle l'élément chauffant 4 n'est plus droit. Cette valeur limite peut être de 250MPa, de préférence de 200MPa.

Par exemple, l'élément chauffant 4 peut comprendre au moins une couche de Nickel revêtue d'au moins une couche de Tungstène, les épaisseurs de ces couches étant adaptées pour obtenir une contrainte résiduelle totale inférieure à la valeur limite.

En particulier, l'élément chauffant 4 pourra comporter une première couche de platine, au moins une bicouche formée par une couche de Nickel (Ni) revêtue d'une couche de Tungstène (W) et une deuxième couche de platine. Le platine permet d'empêcher l'oxydation des autres métaux.

Ces dépôts peuvent être réalisés par pulvérisation cathodique. Cette technique utilise un plasma de gaz inerte, tel que l'Argon, pour pulvériser une cible du matériau à déposer (Ni ou W). La pression d'argon employée est comprise entre 0,9Pa et 3,1 Pa, ce qui correspond respectivement à un débit d'Argon compris entre 25sccm (cm³/min) et 110sccm.

Le plasma est créé entre la cible (polarisée négativement) et le substrat (polarisé positivement), et ainsi les atomes arrachés à la cible sont dirigés vers le substrat. Le plasma a été densifié et concentré à l'aide du champ magnétique crée par un magnétron pour augmenter la vitesse de dépôt. La puissance RF choisie pour le magnétron est de 300W.

Dans la gamme de pressions de gaz inerte comprise entre 1,2Pa et 3,1Pa, le demandeur a constaté que la tension résiduelle dans le Nickel évoluait de façon peu significative et présentait une valeur absolue d'environ 550Mpa. Par ailleurs, dans la gamme de pressions de gaz inerte comprise entre 0,9Pa et 3,1Pa, le demandeur a constaté que la compression résiduelle dans le Tungstène évoluait de façon peu significative et présentait une valeur absolue d'environ 1250Mpa.

Pour compenser les contraintes résiduelles de la couche de Nickel avec celle de la couche de Tungstène, il apparaît donc que l'épaisseur de la couche de Nickel doit être plus élevée que l'épaisseur de la couche de Tungstène, d'un rapport d'environ 2,2.

On pourra donc, dans le cas où l'on souhaite réaliser un élément chauffant de 100nm d'épaisseur, réaliser une couche de 10nm de platine, une couche de Nickel de 55nm, une couche de Tungstène de 25 nm de tungstène et enfin, une couche de 10 nm de platine. Dans ces conditions, les couches de nickel et de tungstène sont compensées en contrainte.

La structure d'isolation thermique 3 peut être réalisée en nitrure de silicium (Si₃N₄) ou en dioxyde de silicium (SiO₂).

Avantageusement, la structure d'isolation thermique comporte plusieurs couches de matériau isolant thermiquement, une couche étant réalisée en un matériau isolant thermiquement et présentant une contrainte résiduelle en tension et la couche attenante étant réalisée en un matériau isolant thermiquement et présentant une contrainte résiduelle en compression, les épaisseurs de ces couches de matériau isolant thermiquement étant adaptées pour compenser les contraintes résiduelles entre les différentes couches afin d'obtenir une contrainte résiduelle totale de la structure inférieure à une autre valeur limite.

La valeur limite peut être de 250MPa.

Par ailleurs, chaque couche est réalisée par dépôt en plaque pleine du matériau concerné par PECVD (pour « *Plasma Enhanced Chemical Vapor Deposition »* selon la terminologie anglo-saxonne) ou LPCVD (pour *« Low-Pressure Chemical Vapor Deposition* » selon la terminologie anglo-saxonne).

Cela permet d'obtenir une structure d'isolation thermique relativement épaisse, pour améliorer sa robustesse, tout en s'assurant que les contraintes résiduelles des matériaux utilisés n'engendrent pas un fléchissement de la structure. La structure d'isolation thermique 3 peut ainsi rester parfaitement droite, ce qui est d'importance pour les ponts 33, 34.

Par exemple, la structure d'isolation thermique 3 peut comprendre au moins une bicouche formée d'une couche de dioxyde de silicium et d'une couche de nitrure de silicium, dont les épaisseurs sont choisies pour obtenir une contrainte résiduelle totale inférieure à la deuxième valeur limite.

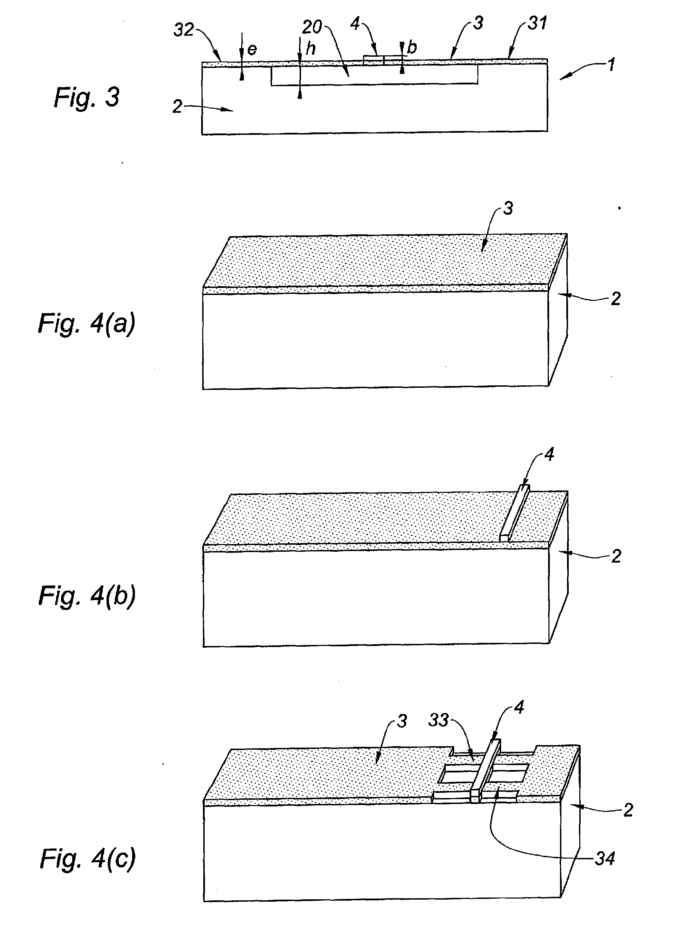

Nous allons maintenant décrire un procédé de fabrication du capteur représenté sur les figures 1 à 3, à l'appui des figures 4(a) à 4(d).

L'étape (a) consiste à déposer une couche de matériau isolant thermique 3 sur le substrat 2 ; cf. figure 4(a).

L'étape (b) consiste à déposer l'élément chauffant 4, réalisé en un matériau conducteur de l'électricité, sur la couche de matériau thermique, cf. figure 4(b).

Puis, lors d'une étape (c), on réalise une gravure sous plasma de la structure obtenue à l'étape (b) pour définir les ponts 33, 34 de la structure d'isolation thermique 3, cf. figure 4(c).

Cette gravure peut s'effectuer sous CHF₃/CF₄. Il s'agit d'une gravure anisotrope, en l'occurrence verticale, permettant de graver la structure d'isolation thermique 3 jusqu'au substrat 2, lequel est généralement réalisé en silicium. Pour cette gravure, les paramètres de plasma suivants peuvent être utilisés : puissance de 180W, pression de 100mTorr et enfin, un débit de 20sccm pour chacun des deux gaz CHF₃ et CF₄.

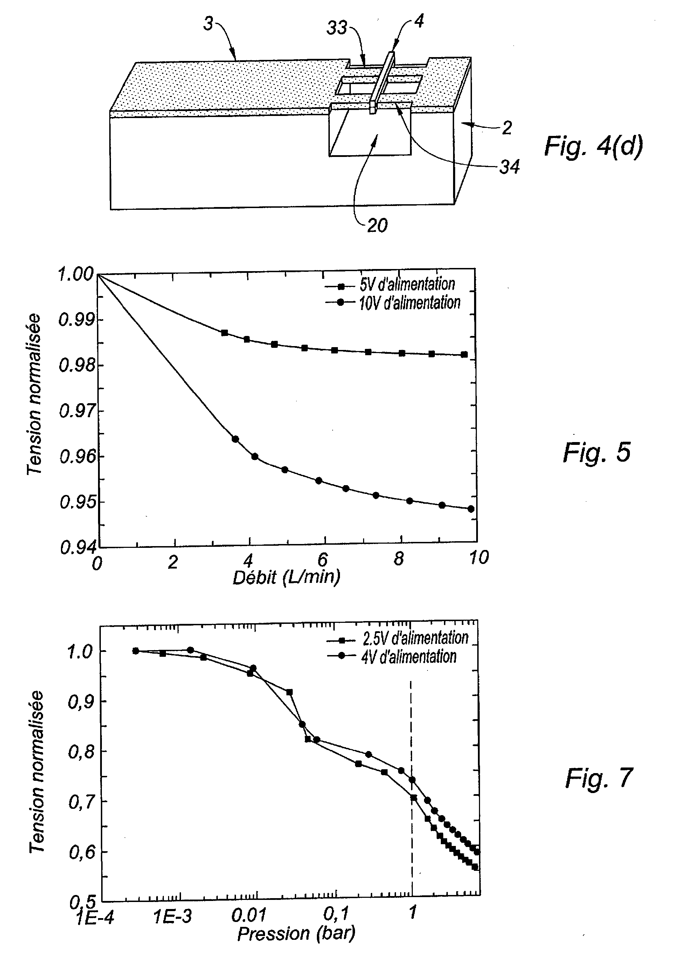

Enfin, on réalise lors d'une étape (d) une gravure par voie chimique gazeuse pour définir la cavité 20, en l'occurrence dans le substrat, cavité 20 au-dessus de laquelle les ponts 33, 34 de la structure d'isolation thermique 3 s'étendent, cf. figure 4(d).

Cette gravure peut s'effectuer sous XeF₂, par exemple sous une pression de 5 Torr. Elle peut également s'effectuer sous SF₆/0₂, par exemple avec les paramètres de plasma suivants : puissance de 180W, pression de 100mTorr, 20sccm de débit pour le SF₆ et 5sccm de débit pour l'O₂ de façon à obtenir une gravure isotrope. Cette gravure s'effectue dans le substrat afin de libérer les ponts 33, 34 de la structure d'isolation thermique.

Les contacts électriques sont ensuite réalisés sur la structure d'isolation thermique 3, au niveau des extrémités de l'élément chauffant 4. Cette dernière étape n'est pas représentée.

Dans ce procédé, la structure d'isolation thermique 3 comprend également une lame 35 sous l'élément chauffant 4, entre les deux ponts 33, 34. Ceci confère un surcroît de robustesse au capteur 1 représenté sur les figures 1 à 3.

La figure 5 représente une caractérisation du capteur 1 représenté sur les figures 1 à 3.

Cette figure représente l'évolution du débit normalisé et de la vitesse dans le micro-canal formé par la cavité 20, en fonction du temps, pour un jet d'air pulsé dans la cavité, à une fréquence de 200Hz.

La cavité 20 présente en l'occurrence une section L*h = 40µm*5µm.

L'élément chauffant 4 est réalisé en Platine, dont le TCR est d'environ 2400 ppm/°C.

La structure d'isolation thermique est une multicouche SiO₂/ Si₃N₄/SiO₂/Si₃N₄/SiO₂ dont les épaisseurs respectives sont de l'ordre de 100nm/20nm/100nm/20nm/100nm. La largeur l d'un pont 33, 34 est de 10µm et la distance D entre les deux ponts est de 20µm.

Cette figure représente également les mêmes évolutions pour un capteur commercial, constitué par un fil chaud DANTEC de 1,5mm (réf : 9055P0111).

On observe une bonne concordance entre les mesures effectuées par le capteur 1 selon l'invention et le capteur commercial.

Par ailleurs, la sensibilité du capteur 1 selon l'invention a été mesurée à 70mV/(L.mn⁻¹)^{0.32} pour une puissance consommée de 20mW.

Cette sensibilité exprime l'évolution de la tension mesurée aux bornes d'un pont de Wheatstone connecté aux bornes de l'élément chauffant 4, en fonction de la valeur du débit dans la cavité 20. Dans la mesure où l'élément chauffant 4 est parcouru par un courant constant, la variation de la tension aux bornes du pont de Wheatstone représente la variation de la température et par suite de la résistance électrique de l'élément chauffant 4, en fonction de la valeur du débit dans la cavité.

Le pont de Wheatstone facilite la mesure de la variation de température de l'élément chauffant 4 en éliminant la composante continue de la résistance de cet élément 4.

Cette sensibilité est excellente.

Par ailleurs, le capteur 1 ainsi testé présente une fréquence de coupure d'environ 5kHz, à courant constant.

Il peut également être utilisé pour mesurer des vitesses élevées, allant bien au-delà de 20m/s et même au-delà de 100m/s.

Le capteur 1 représenté sur les figures 1 à 3 permet notamment de réaliser des mesures de vitesse et de frottement pariétal. Ce capteur peut également être utilisé pour mesurer une pression dans une gamme de valeurs comprise entre 0,1 Pa et 10⁴ Pa.

Ce capteur peut également être adapté pour mesurer des pressions plus élevées, allant typiquement jusqu'à 10⁶Pa.

En effet, la fabrication d'une cavité 20 de hauteur faible, typiquement comprise entre 50nm et 500nm, permet d'utiliser le capteur comme un capteur 1' de pression utilisant l'effet Pirani, pour des pressions de l'ordre de grandeur de la pression atmosphérique (0,1 bar à 10 bars).

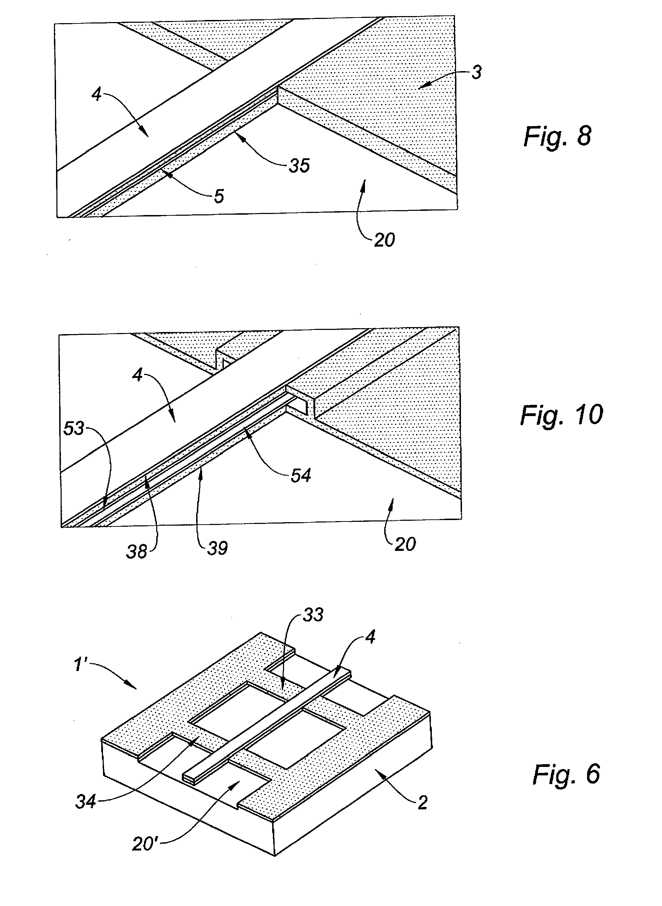

Cette variante de réalisation est représentée sur la figure 6. Sur cette figure 6, la hauteur de la cavité 20 est en effet plus faible que la hauteur de la cavité 20 représentée sur la figure 1.

La figure 7 représente l'évolution de la tension normalisée aux bornes du pont de Wheatstone, en fonction de la pression dans la cavité, cette dernière présentant une section L*h = 40µm*300nm. Les autres caractéristiques du capteur 1' sont les mêmes que celles du capteur 1 employé pour le test de la figure 5.

Les caractéristiques du capteur sont mesurées dans une chambre pressurisée, le capteur n'étant soumis à aucun écoulement. La mesure est donc conductive.

Sur cette figure 7, on observe que le capteur à effet Pirani peut effectivement être employé entre 10Pa et 10⁶Pa. De plus, la sensibilité de ce capteur est d'environ 1mV/décade au-delà d'une pression de 1 bar, pour une puissance consommée de 10mW.

Lorsque le capteur est utilisé comme capteur de pression, il permet également d'obtenir un capteur de pression robuste, c'est-à-dire capable de résister à des pressions élevées, sensible et offrant une large bande passante.

On montre ainsi que le capteur 1, 1' selon l'invention peut être utilisé pour effectuer de nombreuses mesures, à savoir des mesures de vitesse à vitesses élevées (> 100m/s envisageable) ou plus faibles, des mesures de frottement pariétal et également, des mesures de pression en répondant aux exigences de robustesse et de sensibilité, ainsi qu'à l'exigence d'élargissement de la bande passante par rapport aux capteurs connus.

Le capteur selon l'invention peut présenter plusieurs variantes de réalisation.

Dans la variante représentée sur la figure 8, on insère un ruban 5 conducteur de l'électricité dans la lame 35 de la structure d'isolation thermique 3 qui est située sous l'élément chauffant 4 et entre les deux ponts 33, 34. Le ruban 5 est ainsi isolé électriquement de l'élément chauffant 4.

Dans ces conditions, le ruban 5 peut être utilisé comme une résistance de mesure de référence permettant d'effectuer directement une mesure de température différentielle avec l'élément chauffant 4. Il est alors possible de mesure directement la variation de température de l'élément chauffant 4 parcouru par un courant constant, sans utiliser un pont de Wheatstone à l'extérieur du capteur.

La mesure effectuée est donc simplifiée par rapport au capteur 1 représenté sur les figures 1 à 3.

Pour fabriquer cette variante de réalisation, des étapes additionnelles doivent être prévues entre les étapes (a) et (b) mentionnées précédemment. En effet, après avoir déposé une couche de matériau isolant thermique sur le substrat selon l'étape (a), on dépose le ruban 5 localement, puis, on dépose une nouvelle couche de matériau isolant thermique. Les étapes (b) à (d) peuvent alors être réalisées.

Le ruban 5 peut être réalisé en Argent, Aluminium, Nickel, Tungstène ou Platine.

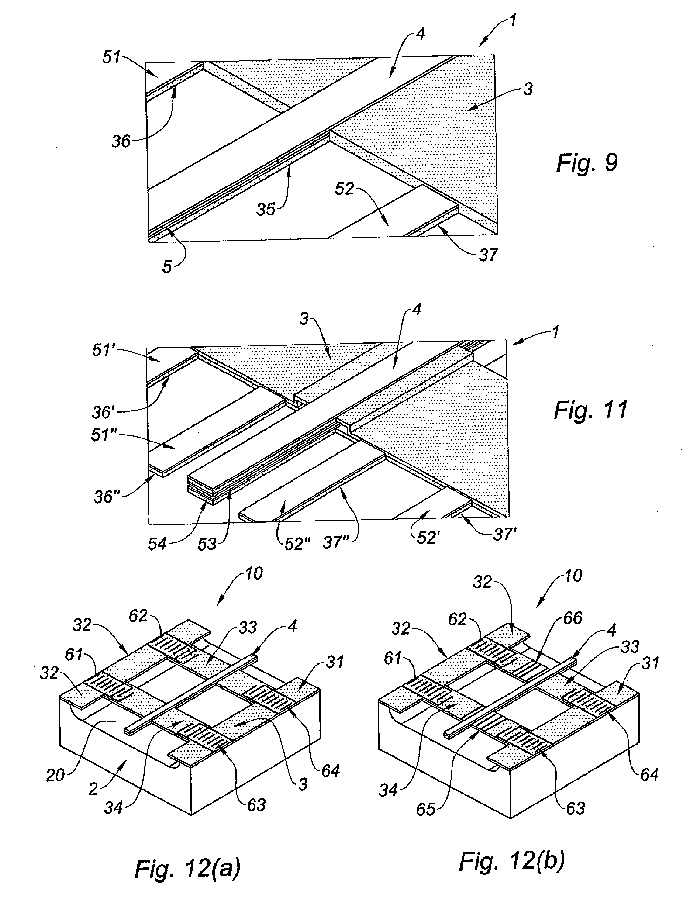

Dans la variante représentée sur la figure 9, un ruban 5 conducteur de l'électricité est également inséré dans la lame 35 de la structure d'isolation thermique 3 qui est située sous l'élément chauffant 4 et entre les deux ponts 33, 34. Le ruban 5 est isolé électriquement de l'élément chauffant 4 et peut être utilisé comme une résistance de mesure (référence). Le ruban 5 peut être réalisé en Argent, Aluminium, Nickel, Tungstène ou Platine.

Cette conception est similaire à celle de la variante représentée sur la figure 8.

Cependant, la structure d'isolation thermique 3 représentée sur la figure 9 comprend, en outre, deux lames additionnelles 36, 37, reliant les deux ponts 33, 34 entre eux et qui sont disposés parallèlement à l'élément chauffant 4, de part et d'autre de celui-ci. Par ailleurs, chacune de ces lames additionnelles 36, 37 est recouverte d'un ruban 51, 52 matériau conducteur de l'électricité, similaire au ruban 5.

Ces rubans 51, 52 servent de résistances de mesures additionnelles. On peut ainsi mesurer, en outre, l'intensité et la direction d'une vitesse d'écoulement. En effet, en l'absence de tout écoulement, les deux résistances de mesure 51, 52 sont à la même température. En revanche, en présence d'un écoulement, les deux résistances de mesure ont des températures distinctes, et cette différence de température permet de déterminer l'intensité et la direction de l'écoulement. On peut également mesurer une constante de diffusion thermique du fluide de la cavité.

Pour fabriquer les lames 36, 37 recouvertes par les rubans 51, 52, il suffit soit de modifier l'étape (b), soit d'ajouter une étape entre les étapes (a) et (b) ou entre les étapes (b) et (c), en déposant les rubans 51, 52 de matériau conducteurs de l'électricité sur la structure d'isolation thermique 3 déposée à l'étape (a). Lors de l'étape (c) de gravure sous plasma, seule la structure d'isolation thermique non recouverte en matériau conducteur électrique est gravée.

Une autre variante d'un capteur selon l'invention est représentée sur la figure 10.

Dans cette variante, deux rubans conducteurs de l'électricité 53, 54 séparés par une fine lame d'air sont prévus sous l'élément chauffant 4. Le premier ruban 53 est séparé de l'élément chauffant 4 par une lame 38 faisant partie de la structure d'isolation thermique 3 et le deuxième ruban 54 est supporté par une autre lame 39 faisant également partie de la structure d'isolation thermique. La lame d'air séparant les deux rubans 53, 54 est de quelques nanomètres. Les rubans 53, 54 sont donc isolés électriquement de l'élément chauffant.

Par rapport au dispositif décrit à l'appui de la figure 8, cette variante de réalisation permet d'accéder à certaines propriétés du fluide (conductivité, diffusivité,...), en écoulement raréfié.

Pour fabriquer cette variante de réalisation, il convient d'effectuer des étapes additionnelles entre les étapes (a) et (b) mentionnées précédemment.

En effet, conformément à l'étape (a), on procède à un dépôt d'une couche d'un matériau isolant thermiquement sur le substrat.

Les étapes additionnelles sont les suivantes.

On dépose le ruban 54 inférieur, localement sur la couche de matériau isolant thermiquement. Avantageusement, mais non nécessairement, on réalise ensuite un dépôt d'une fine couche d'isolant électrique pour limiter les risques de court-circuit dans le capteur. On procède ensuite au dépôt localisé d'une couche sacrificielle, supprimée par la suite pour former la fine lame d'air entre les deux rubans 53, 54. Le dépôt du ruban 53 supérieur est ensuite effectué sur la couche sacrificielle. Puis, le dépôt d'une nouvelle couche de matériau isolant thermiquement est effectué, cette couche étant destinée à supporter l'élément chauffant 4.

Une fois ces étapes réalisées, on reprend les étapes (b) à (d) décrites précédemment.

Une autre variante d'un capteur selon l'invention est représentée sur la figure 11.

Dans cette variante, les rubans 53, 54 conducteurs de l'électricité séparés par une lame d'air sont prévus, de manière similaire à la variante de réalisation décrite à l'appui de la figure 10. Par ailleurs, plusieurs lames 36', 36", 37', 37" appartenant à la structure d'isolation thermique 3, chacune recouvertes d'un ruban 51', 51", 52', 52" conducteur de l'électricité sont prévues, de manière similaire à la variante décrite à l'appui de la figure 9.

Cette variante est finalement une combinaison des structures représentées sur les figures 9 et 10. Elle présente donc les avantages conférés par les deux variantes décrites à l'appui des figures 9 et 10.

Les différentes variantes de réalisation du capteur selon l'invention décrites à l'appui des figures 8 à 11 mettent en oeuvre une ou plusieurs résistances de mesure, pour simplifier la mesure par rapport au capteur 1 décrit à l'appui des figures 1 à 3.

L'utilisation de résistances de mesures nécessite autant de circuits de connexion avec l'élément chauffant, pour obtenir les données souhaitées.

La mesure peut encore être améliorée en utilisant une technique de mesure par ondes acoustiques de surface.

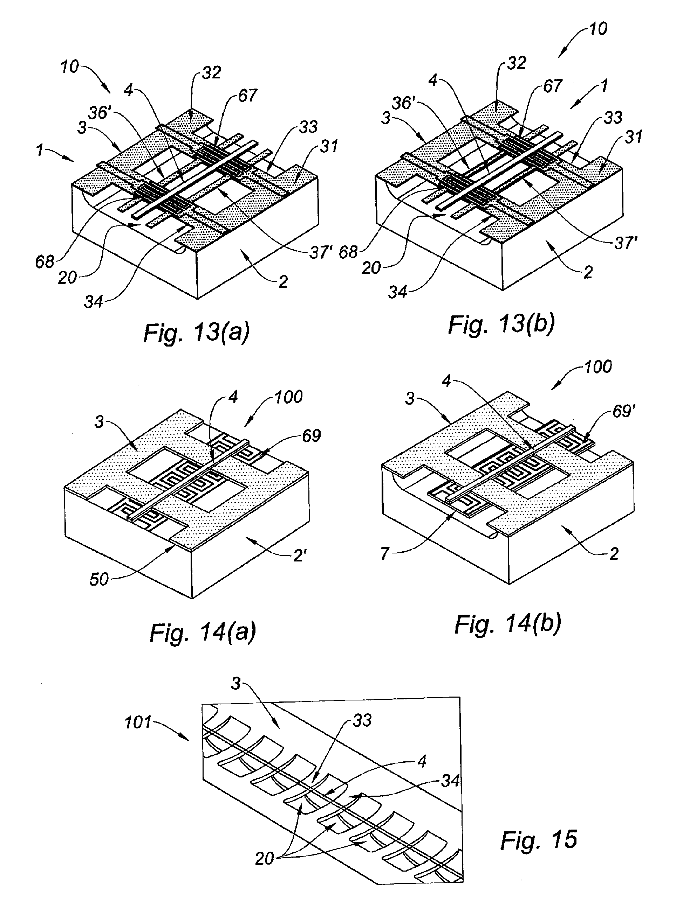

Des capteurs 10 conformes à l'invention utilisant cette technique sont décrits ci-après à l'appui des figures 12(a), 12(b), 13(a) et 13(b).

Une première variante du capteur 10 mettant à profit cette technique est représentée sur la figure 12(a).

Selon cette variante, la structure d'isolation thermique est associée à un matériau piézoélectrique, pour former une structure référencée 3'. Dans ce cas, la structure 3' comprend un isolant thermique, un matériau piézoélectrique et des lignes à retard 61, 62, 63, 64 à ondes acoustiques de surface (émetteur 61, récepteur 63, émetteur 62, récepteur 64), ces lignes à retard étant disposées à chaque jonction entre les ponts 33, 34 et les zones de liaison 31, 32 avec le substrat 2.

La caractéristique du capteur est donnée par la variation de la fréquence de résonance du dispositif en fonction de la variation des propriétés mécanique du matériau utilisé pour le piézoélectrique, cette variation des propriétés mécaniques provenant de la variation de température subie par le capteur.

Une onde acoustique de surface peut ainsi être transmise, par chacun des transducteurs 61, 62 à électrodes interdigitées, disposés le long de la zone de liaison 32 à chacun des transducteurs 63, 64 disposés le long de la zone de liaison 31.

Ces transducteurs à électrodes interdigitées 62, 64 et 61, 63 permettent alors la génération et la détection de l'onde acoustique qui se propage dans le pont 33, 34 sur lequel ils sont respectivement montés.

On simplifie donc les mesures réalisées:

Ces mesures sont en l'occurrence des mesures de la température moyenne de chaque pont 33, 34. Connaissant la température de référence du substrat 2, il est alors possible d'effectuer une mesure de température différentielle au niveau de chaque pont 33, 34, laquelle permet de remonter aux données souhaitées, par exemple une vitesse d'écoulement.

La qualité de la mesure est d'autant meilleure que la présence de ponts 33, 34 permet de réaliser des mesures indépendantes d'un pont à l'autre, et donc de réduire le bruit de mesure par effet de moyennage. La géométrie du capteur est donc particulièrement bien adaptée à la mise en oeuvre d'une technique de mesure par ondes acoustiques de surface pour simplifier la mesure, mais également pour en améliorer la précision.

Pour fabriquer ce capteur, on reprend l'étape (a) décrite précédemment.

Puis, on dépose le matériau piézoélectrique sur la couche d'isolation thermique et on réalise les transducteurs à électrodes interdigitées sur le matériau piézoélectrique.

On met en oeuvre l'étape (b).

L'étape (c) consiste alors à graver à la fois l'isolant thermique et le matériau piézoélectrique qui lui est associé, pour définir la forme des ponts.

Les autres étapes sont inchangées.

Il convient de noter que le matériau piézoélectrique peut être utilisé directement comme couche d'isolation thermique dans le cas où sa conductivité thermique est faible. C'est le cas par exemple des matériaux comme le nitrure d'aluminium et l'oxyde de zinc de structure poly-cristalline, dont la conductivité thermique est comprise entre 10 W.K-¹.m⁻¹et 20 W.K⁻¹.m⁻¹. Dans ce cas, le matériau piézoélectrique forme donc la structure d'isolation thermique.

Le dimensionnement des résonateurs fait partie des connaissances générales de l'homme du métier et n'est donc pas décrit.

Le capteur décrit à l'appui de la figure 12(a) peut faire l'objet d'améliorations.

C'est ce qui est proposé par la variante de la figure 12(b).

Cette variante reprend les caractéristiques du capteur représenté sur la figure 12(a).

Cependant, le pont 33, 34 est muni de réflecteurs 65, 66 comportant un défaut localisé. Ceci permet de mesurer la température du pont localement, au niveau du défaut. La conséquence, par rapport au capteur décrit à l'appui de la figure 12(a), est une mesure de la température localisée au niveau du défaut. Cette mesure est basée sur l'analyse du coefficient de réflexion et non sur la transmission entre transducteurs.

La mesure de température localisée au niveau du défaut permet par exemple de mesurer la température sous l'élément chauffant, si le défaut est situé à ce niveau. Dans la mesure où la température est maximale à ce point, on maximise la sensibilité du capteur, par rapport à un capteur tel que celui de la figure 12(a) pour lequel la mesure d'une température moyenne est effectuée. Par ailleurs, on devrait également améliorer le temps de réponse du capteur et donc accroître sa bande passante. Le procédé de fabrication de ce capteur est similaire au procédé de fabrication du capteur représenté sur la figure 12(a).

Les figures 13(a) et 13(b) proposent d'autres réalisations d'un capteur conforme à l'invention mettant à profit une mesure par ondes acoustiques de surface.

Là encore, la structure 3' comporte un isolant thermique et un matériau piézoélectrique. Elle comprend cependant des lames 36', 37', disposées entre les deux ponts 33, 34, de part et d'autre de l'élément chauffant 4.

Les transducteurs émetteur 67 et récepteur 68 se présentent sous la forme de doigts interdigités sur chacun des ponts 33, 34 de la structure 3'.

Cette disposition permet à l'onde acoustique de surface générée par exemple par le transducteur 67 de se propager dans les lames 36', 37', onde dont les caractéristiques sont modifiées par les conditions environnementales.

Il convient de noter que la géométrie de ce capteur est proche de celle du mode de réalisation de l'invention décrit à l'appui de la figure 9.

Il permet donc d'obtenir le même type d'informations (intensité et direction d'une vitesse, constante de diffusion du fluide,...) mais avec une mesure simplifié liée à la mise en oeuvre de le technique de mesure par ondes acoustiques de surface.

Pour fabriquer ce capteur, il conviendra, après l'étape (a) de dépôt d'une couche d'isolation thermique sur le substrat, de déposer un matériau piézoélectrique sur couche d'isolation thermique et de fabriquer les transducteurs 67, 68 par dépôt sur la couche piézoélectrique. Avantageusement, mais non nécessairement, on réalise ensuite un dépôt d'une fine couche d'isolant électrique pour limiter les risques de court-circuit dans le capteur. Puis, l'étape (b) de dépôt de l'élément chauffant peut être réalisée. L'étape (c) de gravure consiste alors à fabriquer, en même temps, les ponts 33, 34 et les lames 36', 37'. On reprend enfin l'étape (d).

Dans la variante représentée sur la figure 13(b), le capteur reprend toutes les caractéristiques du capteur représenté sur la figure 13(a) et prévoit, en outre, des lames 36', 37' fonctionnalisées pour obtenir un capteur offrant des propriétés additionnelles.

Dans le cas d'espèce, deux lignes conductrices (non référencées) de l'électricité sont déposées sur chaque lame 36', 37', ce qui permet d'obtenir une fonction de filtre.

Pour les modes de réalisation présentés à l'appui des figures 12(a) à 13(b), la structure d'isolation thermique peut être associée avec différents matériaux piézoélectriques tels que le nitrure d'aluminium (AIN), l'oxyde de Zinc (ZnO) ou le nitrure de gallium (GaN).

La technique de mesure par ondes acoustiques de surface peut également être utilisée en combinaison avec l'effet Pirani, pour mesurer des pressions de l'ordre de grandeur de la pression atmosphérique (barométrique).

Les figures 14(a) et 14(b) représentent deux variantes de réalisation du capteur selon l'invention, pouvant être employées à cet effet.

Sur la figure 14(a), le capteur 100 comprend un substrat 2' réalisé en un matériau piézoélectrique à la surface duquel est disposé un transducteur à électrodes interdigitées 69. Le transducteur 69 est disposé en vis-à-vis de l'élément chauffant 4 et à une faible distance de la structure d'isolation thermique 3, par exemple entre 100nm et 500nm pour bénéficier de l'effet Pirani.

Sous l'effet de la pression, la température de l'élément chauffant 4 est modifiée. La modification de cette température modifie les caractéristiques de l'onde de surface se propageant à la surface du substrat 2', modifications qui sont amplifiées par le résonateur 69. L'analyse de l'onde acoustique de surface ainsi modifiée permet de déterminer la variation de température de l'élément chauffant 4, puis d'en déduire la pression dans la cavité 20.

Là encore, cette variante permet de simplifier la mesure, par rapport au capteur 1' décrit à l'appui de la figure 6.

Pour fabriquer ce capteur, on réalise tout d'abord le transducteur à électrodes interdigités 69 sur le substrat piézoelectrique 2'. Puis, on réalise un dépôt localisé d'une couche sacrificielle 50, laquelle permet, à l'étape (d), de définir la cavité. Ensuite, on réalise le dépôt de la couche thermique isolante conformément à l'étape (a), par exemple en SiO2/SiN et le dépôt de l'élément chauffant 4 conformément à l'étape (b). L'étape de gravure anisotrope de l'isolant thermique selon l'étape (c) est effectuée pour former les ponts et enfin, l'étape de gravure isotrope de la couche sacrificielle selon l'étape (d) est réalisée.

Le capteur 100 représenté sur la figure 14(b) propose une amélioration du capteur représenté sur la figure 14(a).

Dans cette variante, le substrat 2 n'est plus réalisé en un matériau piézoélectrique, mais par exemple en silicium. La structure est composée de la structure d'isolation thermique 3 reporté sur une plaque piézoélectrique 7 libérée du substrat. La plaque 7 comprend par ailleurs, en surface, un transducteur 69', avantageusement identique au résonateur 69, disposée en vis-à-vis de l'élément chauffant 4. De plus, cette plaque 7 est agencée de sorte que la distance la séparant de la structure d'isolation thermique est comprise entre 100nm et 500nm, afin de bénéficier de l'effet Pirani.

L'avantage principal lié à cette variante de réalisation, par rapport au capteur représenté sur la figure 14(a), est d'offrir un meilleur temps de réponse, c'est-à-dire une bande passante élargie. Ceci est principalement dû à la réduction de la masse thermique du capteur lié à l'utilisation d'une plaque en couche mince piézoélectrique. Cette plaque 7 présente typiquement une épaisseur comprise entre 500nm et 4µm.

Pour fabriquer ce capteur, on commence par le dépôt d'une couche mince piézoélectrique sur le substrat 2, puis on réalise le transducteur à électrodes interdigitées sur la couche mince. Ensuite, on dépose une couche sacrificielle sur la couche mince piézoélectrique, on effectue les étapes (a) à (c) citées précédemment, puis une gravure de la couche piézoélectrique afin de définir la plaque 7. Finalement, on termine en réalisant l'étape (d) citée précédemment pour graver la couche sacrificielle afin de définir la cavité.

Dans une autre variante de réalisation de l'invention, on peut fabriquer un capteur 1 dans lequel aucun matériau isolant thermique n'est présent sous l'élément chauffant 4, entre les deux ponts 33, 34.

Pour cela, il convient d'intervertir les étapes (a) et (b) mentionnées précédemment.

L'étape (c) de gravure permet alors de définir les ponts 33, 34 de la structure d'isolation thermique 3 et de supprimer-la couche d'isolation thermique située au-dessus de l'élément chauffant.

L'étape (d) et l'étape de dépôt des contacts électriques sont alors inchangées.

Dans cette variante, la robustesse du capteur est moindre que celle du capteur 1 représenté sur la figure 1, mais sa bande passante est améliorée.

Plus généralement, l'absence de matériau isolant thermiquement sous l'élément chauffant 4 peut être envisagée pour les variantes de réalisation décrites à l'appui des figures 1 à 3, 6, 12(a), 12(b), 13(a), 13(b), 14(a) et 14(b).

Dans tous les modes de réalisation de l'invention décrits précédemment, le capteur 1, 1', 10, 100 est en fait un capteur de maille élémentaire dont la structure d'isolation thermique ne présente que deux ponts 33, 34.

Cependant, la structure du capteur permet d'employer un élément chauffant 4 dont la longueur n'est pas limitée, car la structure d'isolation thermique 3 peut comporter N ponts successifs, avec N supérieur ou égal à 3, afin d'assurer sa robustesse.

Un tel capteur peut être fabriqué avec les étapes (a) à (d), en prévoyant simplement un substrat de longueur adéquate, pour réaliser, en même temps, plusieurs mailles élémentaires en série du capteur. Dans ce cas, le dépôt deux contacts électriques seulement, aux extrémités de l'élément chauffant 4, est suffisant.

La figure 15 représente d'ailleurs une image de ce type de capteur 101, selon une vue en perspective, obtenue avec un microscope électronique à balayage.

Sur cette figure 15, on remarque que les ponts de la structure d'isolation thermique sont incurvés. Ceci est lié aux contraintes internes du matériau. Pour résoudre ce problème, on peut soit diminuer l'épaisseur du matériau formant la couche d'isolation thermique, soit prévoir une multicouche compensée en contrainte comme cela a été précisé précédemment.

Un avantage lié à la mise en oeuvre d'un capteur à N ≥ 3 mailles élémentaires est d'homogénéiser la valeur de la température le long de l'élément chauffant 4, par limitation des effets de bord. On améliore ainsi la précision de la mesure effectuée.

Par ailleurs, il convient de noter que le procédé de fabrication du capteur représenté sur les figures 1 à 3 peut être modifié pour fabriquer, en parallèle, deux types de capteurs.

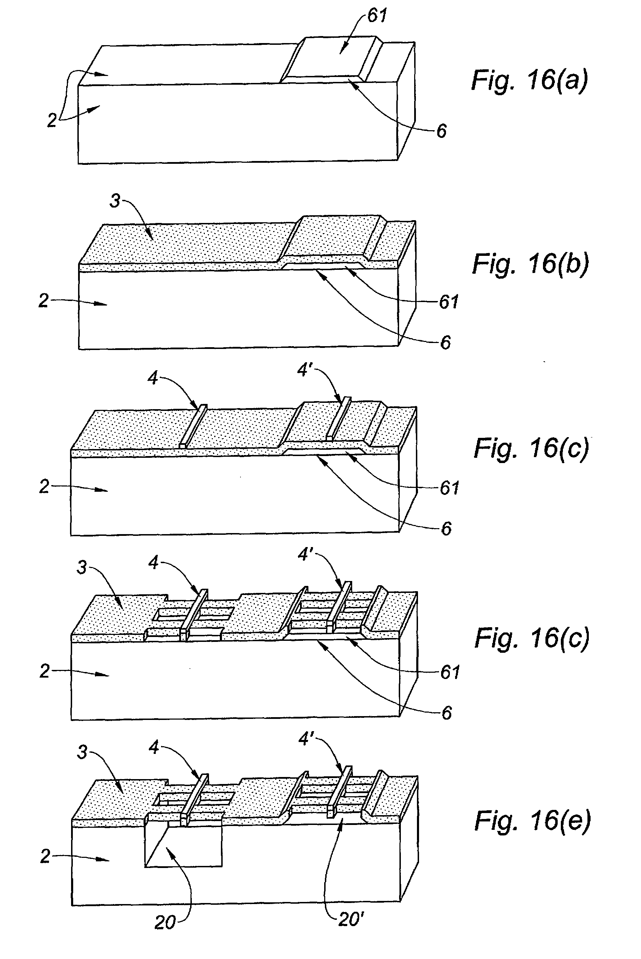

Par exemple, les figures 16(a) à 16(d) représentent les différentes étapes de fabrication d'un double capteur permettant d'une part, de mesurer une vitesse d'écoulement et/ou une contrainte pariétale et d'autre part, une pression par effet Pirani.

A cet effet, on dépose localement une couche mince d'aluminium 6 sur le substrat 2, puis une couche d'épaisseur prédéterminée de silicium amorphe sur la couche mince en aluminium. On obtient alors la structure représentée sur la figure 16(a).

Ensuite, on reprend les étapes (a) à (d) décrites précédemment, qui aboutissement chacune et respectivement sur les structures représentées sur les figures 16(b) à 16(d).

En particulier, il convient de noter que l'étape (c) consiste alors à déposer deux éléments chauffants 4, 4', un pour chaque capteur.

L'intérêt du dépôt localisé de la couche d'aluminium revêtue d'une couche de silicium amorphe intervient lors de l'étape (d).

En effet, ceci permet d'obtenir une cavité 20 de hauteur plus importante que la hauteur de la cavité 20', pour un temps de gravure par voie chimique gazeuse identique. La couche d'aluminium sert de couche d'arrêt, après élimination de la couche sacrificielle de silicium amorphe, pour s'assurer que la hauteur de la cavité 20' est parfaitement contrôlée, par exemple à une valeur de 300nm permettant d'obtenir l'effet Pirani.

On peut donc multiplier la nature des mesures effectuées par le capteur.

Bien entendu, le procédé qui vient d'être décrit ne présente que les mailles élémentaires du capteur. Il est tout à fait envisageable de répéter N fois cette maille élémentaire, tant pour le capteur de pression que pour le capteur de vitesse/frottement pariétal.

Ce procédé n'est par ailleurs qu'un exemple et les différentes variantes de réalisation décrites à l'appui des figures 6, 8 à 11, 12(a) à 14(b) peuvent être agencés en parallèles, répétés N fois avec N ≥ 3, à souhait.

Cela confère une grande liberté de conception pour le capteur.

## Revendications

1. Capteur (1, 1', 10, 100, 101) miniaturisé à élément chauffant comportant un substrat (2, 2'), une cavité (20, 20') et une structure d'isolation thermique (3) suspendue au-dessus de la cavité par l'intermédiaire de zones de liaison (31, 32) avec le substrat (2, 2'), **caractérisé en ce que** la structure d'isolation thermique (3) comprend au moins deux ponts (33, 34) s'étendant au-dessus de la cavité (20, 20') entre ses deux zones de liaison (31, 32) avec le substrat, l'élément chauffant (4, 4') étant supporté par les ponts (33, 34) en s'étendant transversalement par rapport aux ponts.

2. Capteur selon la revendication 1, dans lequel la longueur L d'un pont (33, 34) est comprise entre 10µm et 80µm.

3. Capteur selon l'une des revendications précédentes, dans lequel la largeur l d'un pont (33, 34) est comprise entre 5µm et 10µm.

4. Capteur selon l'une des revendications précédentes, dans lequel la distance D entre les deux ponts (33, 34) est comprise entre 20µm et 40µm.

5. Capteur selon l'une des revendications précédentes, dans lequel l'épaisseur e de la structure d'isolation thermique (3), en particulier des ponts (33, 34), est comprise entre 100nm et 500nm.

6. Capteur selon l'une des revendications précédentes, dans lequel la hauteur h de la cavité (20, 20') est comprise entre 50nm et 500µm.

7. Capteur selon l'une des revendications précédentes, dans lequel la largeur a de l'élément chauffant (4, 4') est comprise entre 1µm et 5µm.

8. Capteur selon l'une des revendications précédentes, dans lequel l'épaisseur b de l'élément chauffant (4, 4') est comprise entre 50nm et 500nm.

9. Capteur selon l'une des revendications précédentes, dans lequel l'élément chauffant (4, 4') comporte plusieurs couches de matériau conducteurs de l'électricité, une couche étant réalisée en un matériau présentant une contrainte résiduelle en tension et la couche attenante étant réalisée en un matériau présentant une contrainte résiduelle en compression, les épaisseurs de ces couches étant adaptées pour compenser les contraintes résiduelles entre les différentes couches afin d'obtenir une contrainte résiduelle totale de l'élément chauffant inférieure à une première valeur limite, par exemple de 250 MPa.

10. Capteur selon la revendication précédente, dans lequel l'élément chauffant (4, 4') comporte :
- une première couche de platine ;
- au moins une bicouche formée par une couche de Nickel revêtue d'une couche de Tungstène ; et
- une deuxième couche de platine.

11. Capteur selon l'une des revendications précédentes, dans lequel la structure d'isolation thermique (3) comporte plusieurs couches de matériau isolant thermiquement, une couche étant réalisée en un matériau isolant thermiquement et présentant une contrainte résiduelle en tension et la couche attenante étant réalisée en un matériau isolant thermiquement et présentant une contrainte résiduelle en compression, les épaisseurs de ces couches de matériau isolant thermiquement étant adaptées pour compenser les contraintes résiduelles entre les différentes couches afin d'obtenir une contrainte résiduelle totale de la structure inférieure à une deuxième valeur limite, par exemple de 250 MPa.

12. Capteur selon la revendication précédente, dans lequel la structure d'isolation thermique (3) comprend au moins une bicouche formée d'une couche de dioxyde de silicium et d'une couche de nitrure de silicium.

13. Capteur selon l'une des revendications précédentes, dans lequel la structure d'isolation thermique (3) comprend une lame (35) s'étendant sous l'élément chauffant (4) entre les deux ponts (33, 34), ladite lame(35) d'isolation thermique intégrant un ruban (5) réalisé en un matériau conducteur électrique, le ruban étant isolé électriquement de l'élément chauffant (4) par ladite lame (5).

14. Capteur selon l'une des revendications 1 à 12, dans lequel la structure d'isolation thermique (3) comprend deux lames (38, 39) s'étendant sous l'élément chauffant (4) entre les deux ponts (33, 34), deux rubans (53, 54) réalisés en un matériau conducteur de l'électricité et séparés par une lame d'air étant disposés entre les deux lames (38, 39) de la structure d'isolation thermique (3), de sorte que ces rubans sont isolés électriquement de l'élément chauffant (4).

15. Capteur selon l'une des revendications précédentes, dans lequel la structure d'isolation thermique (3) comprend au moins deux autres lames (36', 36", 37', 37") d'isolation thermique s'étendant entre les deux ponts (33, 34), de part et d'autre de l'élément chauffant, ces deux autres lames supportant chacun un ruban (51', 51 ", 52', 52") réalisé en un matériau conducteur électrique.

16. Capteur selon l'une des revendications précédentes, dans lequel la structure d'isolation thermique (3') est réalisée en un matériau piézoélectrique déposé sur un isolant thermique et comporte des transducteurs (61 à 64, 67, 68) pour ondes acoustiques de surface.

17. Capteur selon l'une des revendications 1 à 15, dans lequel le substrat (2') étant réalisé en un matériau piézoélectrique, un résonateur (69) à ondes acoustiques de surface est disposé sur le substrat, au fond de la cavité.

18. Capteur selon l'une des revendications 1 à 15, dans lequel il est prévu une plaque (7) en matériau piézoélectrique sur le fond de la cavité (20), ladite plaque (7) étant munie en surface d'un résonateur (69') à ondes acoustiques de surface.

19. Capteur selon l'une des revendications précédentes, dans lequel la structure d'isolation thermique (3) comprend un nombre N de ponts supérieur ou égal à trois sur lesquels l'élément chauffant (4) est disposé.

20. Procédé de fabrication d'un capteur selon l'une des revendications précédentes, **caractérisé en ce qu'**il comprend les étapes suivantes :
(a) déposer au moins une couche de matériau isolant thermique sur un substrat (2) ;
(b) déposer au moins un élément (4, 4') réalisé en un matériau conducteur de l'électricité sur ladite au moins une couche de matériau isolant thermique ;
(c) réaliser une gravure sous plasma de la structure obtenue à l'étape (b) pour définir la forme de la structure d'isolation thermique (3) avec au moins deux ponts (33, 34) s'étendant entre deux zones de liaison (31, 32) de ladite structure d'isolation thermique (3) avec le substrat (2) ;
(d) réaliser une gravure par voie chimique gazeuse pour définir la cavité (20) du substrat au-dessus de laquelle la structure d'isolation thermique (3) s'étend.

21. Procédé selon la revendication précédente, dans lequel, préalablement à l'étape (a), il est prévu une étape de dépôt localisé d'une couche d'arrêt sur le substrat suivie d'une étape de dépôt, sur la couche d'arrêt, d'une couche sacrificielle d'épaisseur prédéterminée.

22. Procédé selon l'une des revendications 20 ou 21, dans lequel l'étape (b) consiste à déposer plusieurs couches de matériaux conducteurs de l'électricité successivement, une couche étant réalisée en un matériau présentant une contrainte résiduelle en tension et la couche attenante étant réalisée en un matériau présentant une contrainte résiduelle en compression, les épaisseurs de ces couches de matériau isolant étant adaptées pour compenser les contraintes résiduelles entre les différentes couches afin d'obtenir une contrainte résiduelle totale de l'élément inférieure à une première valeur limite, par exemple de 250MPa.

23. Procédé selon l'une des revendications 20 à 22, dans lequel l'étape (a) consiste à déposer plusieurs couches de matériaux isolants thermiquement successivement, une couche étant réalisée en un matériau présentant une contrainte résiduelle en tension et la couche attenante étant réalisée en un matériau présentant une contrainte résiduelle en compression, les épaisseurs de ces couches de matériau isolant étant adaptées pour compenser les contraintes résiduelles entre les différentes couches afin d'obtenir une contrainte résiduelle totale de la structure d'isolation thermique inférieure à une deuxième valeur limite, par exemple de 250MPa.

## Patentansprüche

1. Miniaturisierter Sensor (1, 1', 10, 100, 101) mit Heizelement, umfassend ein Substrat (2, 2'), einen Hohlraum (20, 20') und eine Wärmeisolationsstruktur (3), welche über dem Hohlraum über Verbindungszonen (31, 32) mit dem Substrat (2, 2') aufgehängt ist, **dadurch gekennzeichnet, dass** die Wärmeisolationsstruktur (3) wenigstens zwei Brücken (33, 34) umfasst, welche sich über dem Hohlraum (20, 20') zwischen ihren zwei Verbindungszonen (31, 32) mit dem Substrat erstrecken, wobei das Heizelement (4, 4') von den Brücken (33, 34) getragen ist, wobei es sich quer im Verhältnis zu den Brücken erstreckt.

2. Sensor nach Anspruch 1, wobei die Länge L einer Brücke (33, 34) zwischen 10 µm und 80 µm enthalten ist.

3. Sensor nach einem der vorhergehenden Ansprüche, wobei die Breite l einer Brücke (33, 34) zwischen 5 µm und 10 µm enthalten ist.

4. Sensor nach einem der vorhergehenden Ansprüche, wobei der Abstand D zwischen den zwei Brücken (33, 34) zwischen 20 µm und 40 µm enthalten ist.

5. Sensor nach einem der vorhergehenden Ansprüche, wobei die Dicke e der Wärmeisolationsstruktur (3), insbesondere der Brücken (33, 34) zwischen 100 nm und 500 nm, enthalten ist.

6. Sensor nach einem der vorhergehenden Ansprüche, wobei die Höhe h des Hohlraums (20, 20') zwischen 50 nm und 500 µm enthalten ist.

7. Sensor nach einem der vorhergehenden Ansprüche, wobei die Breite a des Heizelements (4, 4') zwischen 1 µm und 5 µm enthalten ist.

8. Sensor nach einem der vorhergehenden Ansprüche, wobei die Dicke des Heizelements (4, 4') zwischen 50 nm und 500 nm enthalten ist.

9. Sensor nach einem der vorhergehenden Ansprüche, wobei das Heizelement (4, 4') mehrere Schichten aus elektrisch leitendem Material umfasst, wobei eine Schicht aus einem Material realisiert ist, welches eine residuelle Zugverspannung aufweist, und die angrenzende Schicht aus einem Material realisiert ist, welches eine residuelle Druckverspannung aufweist, wobei die Dicken dieser Schichten angepasst sind, die residuellen Verspannungen zwischen den verschiedenen Schichten zu kompensieren, um eine gesamte residuelle Verspannung des Heizelements zu erhalten, welche geringer ist als ein erster Grenzwert, z.B. von 250 MPa.

10. Sensor dem vorhergehenden Anspruch, wobei das Heizelement (4, 4') umfasst:
- eine erste Schicht aus Platin;
- wenigstens eine Doppelschicht, welche gebildet ist durch eine Schicht aus Nickel, die bedeckt ist mit einer Schicht aus Wolfram; und
- eine zweite Platinschicht.

11. Sensor nach einem der vorhergehenden Ansprüche, wobei die Wärmeisolationsstruktur (3) mehrere Schichten aus thermisch isolierendem Material umfasst, wobei eine Schicht aus einem thermisch isolierenden Material realisiert ist und eine residuelle Zugverspannung aufweist und die angrenzende Schicht aus einem thermisch isolierenden Material realisiert ist und eine residuelle Druckverspannung aufweist, wobei die Dicken dieser Schichten aus thermisch isolierendem Material angepasst sind, um die residuellen Verspannungen zwischen den verschiedenen Schichten zu kompensieren, um eine gesamte residuelle Verspannung der Struktur zu erhalten, welche geringer ist als ein zweiter Grenzwert, z.B. von 250 MPa.

12. Sensor nach dem vorhergehenden Anspruch, wobei die Wärmeisolationsstruktur (3) wenigstens eine Doppelschicht umfasst, welche gebildet ist aus einer Schicht aus Siliziumdioxid und einer Schicht aus Silizium.

13. Sensor nach einem der vorhergehenden Ansprüche, wobei die Wärmeisolationsstruktur (3) eine Lamelle (35) umfasst, welche sich unter dem Heizelement (4) zwischen den zwei Brücken 33, 34) erstreckt, wobei die Lamelle (35) zur Wärmeisolation ein Band (5) beinhaltet, welches aus einem elektrisch leitenden Material realisiert ist, wobei das Band durch die Lamelle (5) von dem Heizelement (4) elektrisch isoliert ist.

14. Sensor nach einem der Ansprüche 1-12, wobei die Wärmeisolationsstruktur (3) zwei Lammellen (38, 39) umfasst, welche sich unter dem Heizelement (4) zwischen den zwei Brücken (33, 34) erstrecken, wobei zwei Bänder (53, 54), welche aus einem elektrisch leitenden Material realisiert sind und durch einen Luftstreifen getrennt sind, zwischen den zwei (38, 39) Lamellen der Wärmeisolationsstruktur (3) auf solche Weise angeordnet sind, dass diese Bänder von den Heizelement (4) elektrisch isoliert sind.

15. Sensor nach einem der der vorhergehenden Ansprüche, wobei die Wärmeisolationsstruktur (3) wenigstens zwei weitere Lammellen (36', 36'', 37, 37") zur Wärmeisolation umfasst, welche sich zwischen den zwei Brücken (33, 34) auf beiden Seiten des Heizelements erstrecken, wobei diese zwei weiteren Lamellen jeweils ein Band (51', 51'', 52', 52") tragen, welches aus einem elektrisch leitenden Material realisiert ist.

16. Sensor nach einem der vorhergehenden Ansprüche, wobei die Wärmeisolationsstruktur (3') aus einem piezoelektrischen Material realisiert ist, welches auf einem Wärmeisolator deponiert ist und Wandler (61-64, 67, 68) für akustische Oberflächenwellen umfasst.

17. Sensor nach einem der Ansprüche 1-15, wobei das Substrat (2') aus einem piezoelektrischen Material realisiert ist, wobei ein Resonator (69) für akustische Oberflächenwellen am Boden des Hohlraums auf dem Substrat angeordnet ist.

18. Sensor nach einem der Ansprüche 1-15, wobei auf dem Boden des Hohlraums (20) eine Platte (7) aus einem piezoelektrischen Material vorgesehen ist, wobei die Platte (7) an der Oberfläche mit einem Resonator (69') für akustische Oberflächenwellen versehen ist.

19. Sensor nach einem der vorhergehenden Ansprüche, wobei die Wärmeisolationsstruktur (3) eine Anzahl N von Brücken von größer oder gleich drei umfasst, auf welchen das Heizelement (4) angeordnet ist.

20. Verfahren zur Herstellung eines Sensors nach einem der vorhergehenden Ansprüche, **dadurch gekennzeichnet, dass** es die folgenden Schritte umfasst:
(a) Deponieren wenigstens einer Schicht aus thermisch isolierendem Material auf einem Substrat (2);
(b) Deponieren wenigstens eines Elements (4, 4'), welches aus einem elektrisch leitenden Material realisiert ist, auf der wenigstens einen Schicht aus thermisch isolierendem Material;
(c) Realisieren einer Plasmaätzung der bei dem Schritt b) erhaltenen Struktur, um die Form der Wärmeisolationsstruktur (3) zu definieren, wobei die zwei Brücken (33, 34) sich zwischen zwei Verbindungszonen (31, 32) der Wärmeisolationsstruktur (3) mit dem Substrat (2) erstrecken;
(d) Realisieren einer chemischen Gasätzung, um den Hohlraum (20) des Substrats zu definieren, über welchem sich die Wärmeisolationsstruktur (3) erstreckt.

21. Verfahren nach dem vorhergehenden Anspruch, wobei vor dem Schritt (a) ein Schritt eines lokalisierten Deponierens einer Stoffschicht auf dem Substrat, gefolgt von einem Schritt einer Deponierung, auf der Stoppschicht, einer Opferschicht mit vorbestimmter Dicke vorgesehen ist.

22. Verfahren nach einem der Ansprüche 20 oder 21, wobei der Schritt (b) darin besteht, nacheinander mehrere Schichten aus elektrisch leitendem Material zu deponieren, wobei eine Schicht realisiert ist aus einem Material, welches ein residuelle Zugverspannung aufweist, und die angrenzende Schicht realisiert ist aus einem Material, welches eine residuelle Druckverspannung aufweist, wobei die Dicken dieser Schichten aus isolierendem Material angepasst sind, um die residuellen Verspannungen zwischen den verschiedenen Schichten zu kompensieren, um eine gesamte residuelle Verspannung des Elements zu erhalten, welche geringer ist als ein erster Grenzwert, z.B. von 250 MPa.

23. Verfahren nach einem der Ansprüche 20-22, wobei der Schritt (a) darin besteht, mehrere Schichten aus thermisch isolierendem material zu deponieren, wobei eine Schicht aus einem Material realisiert ist, welches eine residuelle Zugverspannung aufweist, und die angrenzende Schicht aus einem Material realisiert ist, welches eine residuelle Druckverspannung aufweist, wobei die Dicken dieser Schichten aus isolierendem Material angepasst sind, um die residuellen Verspannungen zwischen diesen verschiedenen Schichten zu kompensieren, um eine gesamte residuelle Verspannung der Wärmeisolationsstruktur zu erhalten, welche geringer ist als ein zweiter Grenzwert, z.B. von 250 MPa.

## Claims

1. A miniaturized sensor (1, 1', 10, 100, 101) having a heater element and comprising a substrate (2, 2'), a cavity (20, 20'), and a thermally insulating structure (3) suspended over the cavity by means of connection zones (31, 32) connecting it with the substrate (2, 2'), the sensor being **characterized in that** the thermally insulating structure (3) comprises at least two bridges (33, 34) extending over the cavity (20, 20') between its two connection zones (31, 32) with the substrate, the heater element (4, 4') being supported by the bridges (33, 34) by extending transversely relative to the bridges.

2. A sensor according to claim 1, wherein the length L of a bridge (33, 34) lies in the range 10 µm to 80 µm.

3. A sensor according to either preceding claim, wherein the width ℓ of a bridge (33, 34) lies in the range 5 µm to 10 µm,

4. A sensor according to any preceding claim, wherein the distance D between two bridges (33, 34) lies in the range 20 µm to 40 µm.

5. A sensor according to any preceding claim, wherein the thickness e of the thermally insulating structure (3), and in particular of the bridges (33, 34) lies in the range 100 nm to 500 nm.

6. A sensor according to any preceding claim, wherein the height h of the cavity (20, 20') lies in the range 50 nm to 500 µm.

7. A sensor according to any preceding claim, wherein the width a of the heater element (4, 4') lies in the range 1 µm to 5 µm.

8. A sensor according to any preceding claim, wherein the thickness b of the heater element (4, 4') lies in the range 50 nm to 500 nm.

9. A sensor according to any preceding claim, wherein the heater element (4, 4') comprises a plurality of layers of electrically conductive material, one layer being made of a material presenting residual stress in tension and the adjacent layer being made of a material presenting residual stress in compression, the thicknesses of these layers being adapted to compensate for the residual stresses among the various layers in order to obtain a total residual stress for the heater element that is less than a first limit value, e.g. 250 MPa.

10. A sensor according to the preceding claim, wherein the heater element (4, 4') comprises:
▪ a first layer of platinum;
▪ at least one bilayer made up of a layer of nickel coated in a layer of tungsten; and
• a second layer of platinum.

11. A sensor according to any preceding claim, wherein the thermally insulating structure (3) comprises a plurality of layers of thermally insulating material, one layer being made of a thermally insulating material that presents residual stress in tension and the adjacent layer being made of a thermally insulating material that presents residual stress in compression, the thicknesses of the layers of thermally insulating material being adapted to compensate for the residual stresses among the various layers so as to obtain a total residual stress for the structure that is less than a second limit value, e.g. 250 MPa.

12. A sensor according to the preceding claim, wherein the thermally insulating structure (3) comprises at least one bilayer formed by a layer of silicon dioxide and a layer of silicon nitride.

13. A sensor according to any preceding claim, wherein the thermally insulating structure (3) includes a strip (35) extending under the heater element (4) between the two bridges (33, 34), said thermally insulating strip (35) incorporating a ribbon (5) made of an electrically conductive material, the ribbon being electrically insulated from the heater element (4) by said strip (35).

14. A sensor according to any one of claims 1 to 12, wherein the thermally insulating structure (3) includes two strips (38, 39) extending under the heater element (4) between the two bridges (33, 34), two ribbons (53, 54) made of electrically conductive material and separated by a strip of air being deposited between the two strips (38, 39) of the thermally insulating structure (3), such that the ribbons are electrically insulated from the heater element (4).

15. A sensor according to any preceding claim, wherein the thermally insulating structure (3) includes at least two other thermally insulating strips (36', 36", 37', 37") extending between the two bridges (33, 34) on either side of the heater element, each of these two other strips including a ribbon (51', 51", 52', 52") made of an electrically conductive material.

16. A sensor according to any preceding claim, wherein the thermally insulating structure (3') is made of a piezoelectric material deposited on thermal insulation and including transducers (61 to 64, 67, 68) for surface acoustic waves.

17. A sensor according to any one of claims 1 to 15, wherein the substrate (2') is made of a piezoelectric material, and a surface acoustic wave resonator (69) is deposited on the substrate, at the bottom of the cavity.

18. A sensor according to any one of claims 1 to 15, wherein a plate (7) of piezoelectric material is provided on the bottom of the cavity (20), said plate (7) being provided on its surface with a surface acoustic wave resonator (69').

19. A sensor according to any preceding claim, wherein the thermally insulating structure (3) has N bridges on which the heater element (4) is deposited, where N is greater than or equal to three.

20. A method of fabricating a sensor according to any preceding claim, the method being **characterized in that** it comprises the following steps:
a) depositing at least one layer of thermally insulating material on a substrate (2);
b) depositing at least one element (4, 4') made of an electrically conductive material on said at least one layer of thermally insulating material;
c) subjecting the structure obtained in step b) to plasma etching in order to define the shape of the thermally insulating structure (3) with at least two bridges (33, 34) extending between two connection zones (31, 32) connecting said thermally insulating structure (3) with the substrate (2); and
d) performing gaseous chemical etching to define the cavity (20) of the substrate over which the thermally insulating structure (3) extends.

21. A method according to the preceding claim, wherein prior to step a), there is provided a step of locally depositing a top layer on the substrate followed by a step of depositing a sacrificial layer of predetermined thickness on the top layer.

22. A method according to claim 20 or claim 21, wherein step b) consists in depositing a plurality of electrically conductive material layers in succession, one layer being made of a material presenting residual stress in tension and the adjacent layer being made of a material presenting residual stress in compression, the thicknesses of these layers of insulating material being adapted to compensate the residual stresses among the various layers in order to obtain a total residual stress for the element that is less than a first limit value, e.g. 250 MPa.

23. A method according to any one of claims 20 to 22, wherein step a) consists in depositing a plurality of layers of thermally insulating material in succession, one layer being made of a material presenting residual stress in tension and the adjacent layer being made of a material presenting residual stress in compression, the thickness of these layers of insulating material being adapted to compensate the residual stresses among the various layers so as to obtain a total residual stress for the thermally insulating structure that is less than a second limit value, e.g. 250 MPa.
